(19) **Europäisches Patentamt European Patent Office Office européen des brevets**

(11) **EP 4 745 584 A1**

(12) # EUROPEAN PATENT APPLICATION

(43) Date of publication:
20.05.2026 Bulletin 2026/21

(21) Application number: 24213465.8

(22) Date of filing: 17.11.2024

(51) International Patent Classification (IPC):
*G01Q 10/04* (2010.01)    *B81C 99/00* (2010.01)
*G01P 21/00* (2006.01)    *G01Q 40/00* (2010.01)

(52) Cooperative Patent Classification (CPC):
**G01Q 10/045; B81C 99/003; G01P 21/00; G01Q 40/00**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Nanosurf AG**
**4410 Liestal (CH)**

(72) Inventors:
• **Gunstheimer, Hans**
**4410 Liestal (CH)**

• **Adams, Jonathan**
**4410 Liestal (CH)**
• **Hoogenboom, Bart**
**4410 Liestal (CH)**
• **Fläschner, Gotthold**
**4410 Liestal (CH)**
• **Hölscher, Hendrik**
**67547 Worms (DE)**

(74) Representative: **Dumlich, Heiko Alexander**
**Lab14 GmbH**
**C/o Specs Surface Nano Analysis GmbH**
**Voltastraße 5**
**13355 Berlin (DE)**

(54) **METHOD AND DEVICE FOR DETERMINING SAMPLE PROPERTIES**

(57) The present invention relates to determining at least one property of a sample with a device that comprises a micromechanical sensor having an apex. A first quantity indicative of a response of the micromechanical sensor due to an apex-sample-interaction and a second quantity indicative of a response of the micromechanical sensor due to a local actuation force acting locally on or in the micromechanical sensor are obtained. At least one first calibration value for calibrating the first quantity and at least one second calibration value for calibrating the second quantity are provided. The at least one first calibration value is configured for causing a change to one or more determined positions of the apex in the response of the micromechanical sensor due to the apex-sample-interaction. The at least one second calibration value is configured for causing a change to one or more determined positions of the apex in the response of the micromechanical sensor due to the local actuation force acting locally on or in the micromechanical sensor. The at least one property of the sample is determined based on the obtained first quantity, the obtained second quantity, the provided at least one first calibration value and the provided at least one second calibration value.

Fig. 2

**EP 4 745 584 A1**

**Description**

TECHNICAL FIELD

Generally, the present invention pertains to the field of probing samples at nanometre resolution by means of force spectroscopy, e.g. using atomic force microscopy (AFM). In particular, the present invention relates to a method for determining at least one property of a sample with a device that comprises a micromechanical sensor having an apex. Furthermore, the present invention relates to a device configured for determining at least one property of a sample and comprising a micromechanical sensor having an apex. Moreover, the present invention relates to a computer program for determining at least one property of a sample and to a non-transitory computer readable data medium storing the computer program. The present invention may enable accurately measuring forces between a micromechanical sensor and a sample as a function of position that is modulated by actuation due to a change in bending moment in the micromechanical sensor.

BACKGROUND OF THE INVENTION

AFM has emerged as a versatile tool for investigating properties of solid, soft as well as biological matter at the nanoscale. For example, with AFM, it is possible to measure mechanical, electrical and magnetic properties of material surfaces at the nanoscale via measurement of forces acting on a micromechanical sensor having a sensing probe that is scanned over a sample surface. This is commonly addressed by measuring forces between a sensing probe and a sample surface as a function of the distance between sensing probe and sample with this distance being modulated using a piezo actuator. It is also known to actuate the probe, e.g., the micromechanical sensor itself, e.g., by modulation of the power of a laser focused on the micromechanical sensor, causing local and asymmetric heating and hence photothermal actuation of the probe. Thereby, it may be possible to achieve excitation frequencies that are higher than excitation frequencies that are possible for piezo actuation, allowing, e.g., for faster scanning.

SUMMARY OF THE INVENTION

The present invention is based on the objective of providing an improved method for determining at least one property of a sample. The present invention is also based on the objective of providing an improved device for determining at least one property of a sample. Moreover, the present invention is also based on the objective of providing an improved computer program for determining at least one property of a sample and a non-transitory computer readable data medium storing the computer program.

According to the present invention, a method for determining at least one property of a sample with a device that comprises a micromechanical sensor having an apex is proposed. The method comprises the steps of:

- obtaining a first quantity indicative of a response of the micromechanical sensor due to an apex-sample-interaction,

- obtaining a second quantity indicative of a response of the micromechanical sensor due to a local actuation force acting locally on or in the micromechanical sensor,

- providing at least one first calibration value for calibrating, e.g., correcting, the first quantity, the at least one first calibration value being configured for causing a change to one or more determined positions of the apex in the response of the micromechanical sensor due to the apex-sample-interaction,

- providing at least one second calibration value for calibrating, e.g., correcting, the second quantity, the at least one second calibration value being configured for causing a change to one or more determined positions of the apex in the response of the micromechanical sensor due to the local actuation force acting locally on or in the micromechanical sensor, and

- determining the at least one property of the sample based on, e.g., using, the obtained first quantity, the obtained second quantity, the provided at least one first calibration value and the provided at least one second calibration value.

The steps of obtaining a first and second quantity and providing at least one first and second calibration value may be carried out in arbitrary order. For example, one or both of the steps of providing at least one first calibration value and providing at least one second calibration value may be conducted prior to obtaining a first quantity and obtaining a second quantity or *vice versa.*

The present invention includes the recognition that in common AFM applications where the distance between apex and sample is modulated using a piezo actuator, the piezo actuator does not only actuate the micromechanical sensor, but a substantially larger object. Yet, larger objects may imply lower resonance frequencies, limiting the maximum possible bandwidth and hence throughput of a measurement. Moreover, this implementation often implies the excitation of various other mechanical resonances in an experimental setup, which may complicate the overall behaviour and thereby reduce robustness and control. It may be possible to overcome these disadvantages by only actuating a micromechanical sensor such as a flexible cantilever, itself, e.g., by modulation of the power of a laser focused on the micromechanical sensor, causing local and asymmetric heating and hence photothermal excitation of the micromechanical sensor. In other words, in this case the micromechanical sensor is actuated by a local actuation force acting locally in the micromechanical sensor and responds due to the local actuation force acting locally in the micromechanical sensor. Alternative implementations for generating the local actuation force may employ other micromechanical sensors such as a self-actuating cantilever, e.g., by a piezo-electric element embedded in or on the micromechanical sensor, or current carrier for local heating or generation of electromagnetic forces embedded in the micromechanical sensor or generation of electric forces on the micromechanical sensor. In such implementations, however, the local actuation force may act in a different way on the micromechanical sensor than a force that is to be measured between the micromechanical sensor and the sample under investigation. A specific and particularly preferred case is thus photothermal excitation, which actuates a micromechanical sensor by inducing a local bending moment at a predetermined position on and/or in the micromechanical sensor. This may yield a different mechanical response than to-be-measured forces acting between the apex protruding from the micromechanical sensor and the sample.

The present invention now includes the recognition that this different mechanical response may invalidate the calibration of the micromechanical sensor, which typically is set up to detect the response due to forces between the sample and the apex protruding from the micromechanical sensor. For example, optical beam deflection may measure the bending angle of a micromechanical sensor, which only provides an indirect measurement of a position of the apex of the micromechanical sensor. In this case, the relation between bending and position is different when, e.g., a local bending moment is induced for actuation compared with a response to forces acting between the apex and the sample, which may result in an incorrectly calibrated measurement amounting to significant deviations. Hence, with such an invalidated calibration, properties of a sample may only be determined incorrectly.

With the method according to the present invention, it is possible to overcome these drawbacks and to correctly calibrate a measured micromechanical sensor readout also when the same micromechanical sensor is used to detect both, the micromechanical sensor response to the local actuation force and the micromechanical sensor response to forces acting between the apex and the sample. Moreover, with the method according to the present invention, it is possible to calibrate such force measurements even though no direct measurement of the micromechanical sensor position is available. That is, because the method according to the present invention takes into account that a measured sensor signal, e.g., versus time, represents a superposition of a sensor-signal difference due to the apex-sample interaction and an unperturbed sensor signal due to a local actuation force in the sensor, that in general will need to be calibrated differently.

This is possible with the method according to the present invention since a first quantity, at least one first calibration value for calibrating, e.g., correcting, the first quantity, a second quantity, and at least one second calibration value for calibrating, e.g., correcting, the second quantity are used for determining the at least one property of the sample. In particular, the first quantity is indicative of a response of the micromechanical sensor due to an apex-sample-interaction. The at least one first calibration value is configured for causing changes to one or more determined positions of the apex in the response of the micromechanical sensor due to the apex-sample-interaction. In addition to that, a second quantity is indicative of a response of the micromechanical sensor due to a local actuation force acting locally on or in the micromechanical sensor. The at least one second calibration value is configured for causing a change to one or more determined positions of the apex in the response of the micromechanical sensor due to the local actuation force acting locally on or in the micromechanical sensor.

In particular, with the at least one first calibration value and the at least one second calibration value, it is possible to use different calibrations to extract changes in apex position due to (i) apex-sample interactions and (ii) the local actuation force acting locally on or in the micromechanical sensor to change the apex-sample distance. Thus, in the method according to the present invention, the difference in bending is calibrated differently from the bending induced by the change in bending moment apparently unaffected by forces due to the vicinity of the sample. In the proposed method, preferably, the same micromechanical sensor is used to probe apex-sample interactions as well as an apex-sample distance. However, both, the apex-sample interactions and the apex-sample distance are calibrated separately and differently. This allows to accurately obtain apex-sample interaction forces as a function of an apex-sample distance.

Thereby, the method according to the present invention allows accurately determining the at least one property of the sample. For example, mechanical, electrical or magnetic properties can be determined via forces on the apex detected at and/or just above a sample surface. Due to the local actuation force acting locally on or in the micromechanical sensor, it is possible, for example, to achieve higher throughput nanoscale characterization. The method according to the present invention also realizes the advantage that no additional and costly hardware is required to correctly determine the at least one property of the sample.

Due to the local actuation force acting locally on or in the micromechanical sensor, it is possible to overcome speed limitations of conventional atomic force microscopes, e.g., by the possibility of realizing higher excitation frequencies, thereby enabling faster scanning and/or higher resolution or both. With the proposed method, it is also possible to probe a wide selection of samples such as delicate samples like proteins, living cells, virus capsids or the like.

The proposed method may be independent of any feedback scheme that may be used to maintain consistent apex-sample interactions, e.g., in an AFM experiment. Such feedback could be based on an average measurement, on signal amplitude, on any instantaneous signal that has been background-corrected, e.g., background-subtracted, or the like.

Preferably, in the method, the at least one second calibration value includes a phase correction and/or an amplitude correction. A phase correction comprises a phase shift that may be lead or lag compared to a reference phase shift, and an amplitude correction may include an amplitude difference that may be larger or smaller compared to a reference amplitude. Hence, the present invention includes the further recognition that an unperturbed signal, for a given frequency, can be calibrated by amplitude and/or phase corrections. The phase correction and/or the amplitude correction can be determined using various different methods some of which are explained further below. It is possible that several, e.g., at least two phase corrections and/or amplitude corrections are employed. For example, in case of signals containing multiple frequencies, amplitude and/or phase corrections could be employed for several or all frequencies contained in the signal, or at least amplitude and/or phase corrections for a predefined number of frequencies to enable an interpolation or extrapolation to the frequencies contained in the signal. In particular, amplitude and/or phase corrections may be frequency dependent.

In case the at least one second calibration value includes a phase correction and/or an amplitude correction, a calibrated second quantity may be obtained by correcting both amplitude and phase of the change in a bending moment apparently unaffected by forces due to the vicinity of the sample, compared with the calibration that applies when the micromechanical sensor responds to a force between the micromechanical sensor and the sample. Yet, such a correction may not need to be applied to the difference in the bending of the micromechanical sensor due to forces between the apex of the micromechanical sensor and the sample. The amplitude correction may be configured for correcting the amplitude associated with the second quantity. With the amplitude correction, it may be possible to correct a scale used to measure an amplitude of a movement.

In the method, it is possible that the phase correction and/or amplitude correction is determined based on historical data including predetermined amplitude corrections and/or phase corrections for the micromechanical sensor. For example, historical data may include empirically determined and tabulated values for predetermined micromechanical sensors. These tabulated values may be used to estimate the phase correction and/or amplitude correction in an experiment. Optionally, the historical data may be provided in the form of a look up table (LUT), e.g., based on one or more typical phase corrections and/or amplitude corrections measured for one or more predetermined micromechanical sensors. The historical data may further include one or more predetermined positions of the local actuation force acting locally on or in the micromechanical sensor and/or one or more predetermined operation frequencies. For example, for one predetermined type of micromechanical sensor, one laser spot and one frequency, there may be one phase correction and/or amplitude correction. It is possible that the historical data are associated with different micromechanical sensors. However, it is preferred that the historical data are associated with the micromechanical sensor being used for conducting the method.

It is also possible that the phase correction and/or amplitude correction is determined based on a computational model configured for determining the amplitude corrections and/or the phase corrections for the micromechanical sensor for one or more predetermined positions of a local actuation force acting locally on or in the micromechanical sensor and/or one or more predetermined operation frequencies. Preferably, the computational model is a finite element method model. The phase correction and/or amplitude correction may thus be determined employing a finite element method simulation, e.g., of various micromechanical sensor geometries.

Additionally or alternatively, it is possible that the phase correction and/or amplitude correction is determined based on an analytical model that includes one or more properties at least of the micromechanical sensor for determining the amplitude corrections and/or phase corrections for the micromechanical sensor for one or more predetermined positions of a local actuation force acting locally on or in the micromechanical sensor and/or one or more predetermined operation frequencies. For example, the phase correction and/or amplitude correction may be determined using an analytical model, e.g., fed by experimentally measured properties such as a micromechanical sensor geometry, one or more laser spot positions, e.g., obtained from camera images, a frequency sweep behaviour, or the like.

Optionally, in the method, the phase correction and/or amplitude correction may be determined based on repositioning a local actuation force acting locally on or in the micromechanical sensor so that an effective phase correction is zero. For example, the phase correction and/or amplitude correction may be determined using a hard surface of the to-be-measured sample or of a reference sample and by repositioning an excitation laser so that a hysteresis disappears. To correct a phase shift, it is possible to shift a free deflection in time to align its minimum with the maximum peak of the

EP 4 745 584 A1

interaction signal on a hard surface. This shift may eliminate a hysteresis in a force-distance curve. Thus, to correct a phase shift, it is possible to align a force-distance curve to minimize a hysteresis. It is possible to keep track of phase correction and/or amplitude correction values and to plot them as a spatial indication of mechanical properties.

It is also possible that the amplitude and/or phase corrections are determined by comparing optical beam deflection and interferometric measurement of various micromechanical sensors at various spot positions and frequencies and to recognize laser spot positions optically from camera image. For example, it is possible that comparing optical beam deflection and interferometric measurement of various micromechanical sensors at various spot positions and frequencies includes a direct comparison of a measured deflection with a position as measured, e.g., by interferometry, as a function of time. Additionally or alternatively, comparing optical beam deflection and interferometric measurement of various micromechanical sensors at various spot positions and frequencies may include comparing amplitude and phase as measured, e.g., by a lock-in amplifier, against the same reference signal.

In the method, it is possible that the phase correction and/or amplitude correction is determined based on a calibration measurement on a reference structure of known mechanical properties such as against one or more reference samples with known stiffness against one or more reference samples with known stiffness. For example, the one or more reference samples may have a stiffness that significantly exceeds the stiffness of the micromechanical sensor. Accordingly, the one or more reference samples may enable calibration against a hard sample, in which case it may be possible to achieve a slope of -1 nm/nm in the resulting deflection-versus-position curves.

It is also possible that the amplitude and/or phase corrections are determined based on a measurement on a references structure, e.g., a reference sample, of known mechanical properties. Preferred embodiments may include, e.g., a measurement against a reference beam or reference sample of known stiffness. Accordingly, a calibration against reference samples with known stiffness may be preferred.

Furthermore, in the method, it is possible that the phase correction and/or amplitude correction is determined based on applying a known force or distance difference to the apex. For example, applying a known force to the apex may include comparing a measured sensor response caused by the applied local actuation force to an actual, e.g., measured, value of the applied force. Additionally or alternatively, applying a known distance difference to the apex may include comparing a measured sensor response caused by the applied distance difference to an actual, e.g., measured, value of the applied distance difference.

In the method, it is possible that a position for applying the local force on the micromechanical sensor is adjusted to minimize either phase or amplitude corrections. For example, it is possible to employ a sample where no hysteresis is expected, and then to iteratively adjust the actuation position until the observed hysteresis is minimised. Additionally or alternatively, adjusting position for applying the local force on the micromechanical sensor to minimize either phase or amplitude corrections may be realised against a sample under conditions where the expected response of the micromechanical sensor is known. Using such a sample where the expected response of the micromechanical sensor is known for certain conditions, it is possible to iteratively adjust the actuation position until a measured magnitude, e.g. amplitude, of the measured micromechanical sensor response agrees with the expected response.

Additionally or alternatively, in the method, it is possible to determine the phase correction and/or amplitude correction based on measuring a trajectory of the apex, preferably an actual apex trajectory. For example, measuring the actual apex trajectory may be carried out by conducting a displacement measurement with an interferometer.

Optionally, in the method, the second calibration value may be determined based on measuring a response, e.g., a motion, of the micromechanical sensor induced by the local actuation force acting locally on or in the micromechanical sensor with a position-sensitive sensor like an interferometer arranged to measure a displacement of the apex and calibrating a micromechanical sensor readout, e.g. optical beam deflection, based on the position-sensitive sensor arranged to measure a displacement of the apex and calibrating a sensor readout based on the position-sensitive sensor. Additionally, or alternatively, in the method, the second calibration value may be determined based on calibrating the micromechanical sensor to obtain calibrated angular measurements and measuring an angle along the micromechanical sensor during response due to the local actuation force acting locally on or in the micromechanical sensor and integrating the angular measurement along the micromechanical sensor to reconstruct a deformation of the micromechanical sensor to obtain a relation between the angle at a position of the apex of the micromechanical sensor and its displacement.

In the method, it is also possible to determine the second calibration value by measuring a motion of the micromechanical sensor from the local actuation force acting locally on or in the micromechanical sensor with a micromechanical sensor readout and a position-sensitive sensor arranged to measure a displacement of the apex and calibrating a micromechanical sensor readout based on the position-sensitive sensor. This may involve measuring a set of predetermined micromechanical sensors and generating a series of second calibration values that could be applied to other micromechanical sensors.

Since an optical beam deflection readout measures an angular deflection of the micromechanical sensor, it is also possible to first calibrate the micromechanical sensor to get calibrated angular measurements, and then measure the angle along the micromechanical sensor during motion due to the local actuation force. This angle measurement may have both, an amplitude and phase component. It is possible to integrate the angular measurement along the micromechanical sensor to reconstruct the deformation of the micromechanical sensor, hence, acquiring a relation between the angle at the apex of the micromechanical sensor and its displacement.

In the method, it is possible that the phase correction and/or amplitude correction is determined based on a direct strain measurement at the micromechanical sensor. In such a case, a direct strain measurement, such as by piezo-resistive measurement, may be employed to provide additional information on how to compare and determine the at least one first and/or second calibration value.

In the method, it is possible that the phase correction and/or amplitude correction is determined based on measuring a quantity causing a bending moment of the micromechanical sensor. For example, the phase correction and/or amplitude correction may be determined by measuring a quantity causing the bending moment, e.g., temperature measurement, along the micromechanical sensor. For example, measuring the quantity causing a bending moment can be carried out by performing a temperature measurement along a length of the micromechanical sensor when a laser beam focused on a surface on the micromechanical sensor is used for photothermal excitation.

In the method, it is possible that the phase correction and/or amplitude correction is determined through comparison of an actual beam shape of the micromechanical sensor with a known beam behaviour of the micromechanical sensor. For example, the phase correction and/or amplitude correction may be determined through comparison of an actual beam shape with known beam behaviour such as a mode shape. For example, the phase correction and/or amplitude correction can be determined through comparison of an actual beam shape with a known beam behaviour such as a mode shape, a laser spot position, an operation frequency or the like. Optionally, the method may comprise a step of adjusting a spot position of a photothermal excitation laser on the micromechanical sensor.

In the method, it is possible that the phase correction and/or amplitude correction is determined through comparing an optical beam deflection and interferometric measurement of different predetermined micromechanical sensors at one or more different spot positions and frequencies and to recognize laser spot positions optically from camera images.

The method may comprise that the phase correction and/or amplitude correction is determined based on obtaining the first quantity from a measurement of an at least intermittent or transient interaction between the micromechanical sensor and the sample. The apex of the micromechanical sensor, for example, may be intermittently in contact with a surface of the sample for the measurement. In other embodiments, a measurement may be performed when the apex of the micromechanical sensor is at least intermittently in interaction, e.g., in contact, with a hard surface of the to-be-measured sample or a reference sample. If the measurement is performed on a reference sample, a reference first quantity may be obtained, e.g., derived, and the at least one first calibration value may be provided based on the reference first quantity. For example, it is possible to plot the first quantity against the second quantity for the case where the apex-sample interaction is that of a hard contact at least for part of the time and, e.g., zero for the remainder of the time. That way, a slope, e.g., a measured slope or expected slope, of first quantity-vs-second quantity may be -1 for the duration of the hard contact.

Furthermore, it is possible to measure an interaction on a surface of the to-be-measured sample or a reference sample and to compare a point of highest interaction with a point of lowest deflection to get the phase correction. It is possible to compare a slope and to scale amplitude so that slope matches calibration to obtain the amplitude correction. On a hard surface, it is also possible to determine the phase correction and/or amplitude correction by defining the first quantity as a function of the second quantity and determining the phase correction and/or amplitude correction such that a slope of -1 nm/nm is achieved.

That is, it is possible to determine the phase correction and/or amplitude correction by measuring an uncorrected force versus a modulated position by pressing the micromechanical sensor against the to-be-measured sample or a reference sample. In particular, it is possible to determine the phase correction and/or amplitude correction by measuring an uncorrected force versus modulated position by pressing the micromechanical sensor against a hard surface, in which case the corrected data may show a motion of the micromechanical sensor equal to the bending-moment induced change in position and no temporal delay between the change in micromechanical sensor position due to the sample force and due to the bending-moment induced modulation.

In the method, it is also possible that the phase correction and/or amplitude correction is determined based on measuring a deflection of the micromechanical sensor as a function of position along the micromechanical sensor, to reconstruct the bending of the micromechanical sensor over its full length and thereby determining a relation between the actual modulated position and the measured modulated position. For example, it is possible to determine the phase correction and/or amplitude correction by measuring the deflection of the micromechanical sensor at different positions, which may be used to determine the overall bending shape and thereby the phase correction and/or amplitude correction.

Additionally or alternatively, the method may comprise that the phase correction and/or amplitude correction is determined based on modelling a bending of the micromechanical sensor as a function of position along the micromechanical sensor, to reconstruct the bending of the micromechanical sensor over its full length and thereby determining a relation between the actual modulated position and the measured modulated position.

Optionally, the method may comprise that the phase correction and/or amplitude correction is determined based on measuring the second quantity as a function of frequency or time, and by combining these measurement data with a model of the expected response. For example, it is possible to measure the response, e.g., amplitude and phase, of the micromechanical sensor due to the local actuation force for a given local actuation position, as a function of frequency. This can be used to calibrate a model of the expected response, which may be used to calibrate the second quantity.

In the method, it is possible that the phase correction and/or amplitude correction is determined based on a temporal alignment between a feature in the first quantity due to the vicinity of the sample, and a feature in the second quantity, wherein the amplitude correction is determined from a known or modelled relation between the phase correction and the amplitude correction.

In the method, it is possible that the first quantity is derived when the apex is at least transiently or intermittently in contact with the sample. Alternatively or additionally, the second quantity may be derived when the apex is not in contact with the sample.

Optionally, in the method, it is possible that the at least one second calibration value includes at least one correction to the at least one first calibration value. For example, it is possible that the second calibration value is determined as a correction of the first calibration value. However, it is also possible that the at least one first calibration value includes at least one correction to the at least one second calibration value. The first and second calibration values can be used for calibrating, e.g., correcting the first and second quantities in various order and at various times. For example, the first calibration value or the first calibration values and/or the second calibration value or the second calibration values can be employed, e.g., at the beginning of probing properties of a sample, during that measurement, at the end of that measurement or even when determining at least one property of the sample at any time after the measurement using the obtained experimental data of the sample. In any case, as long as experimental data are recorded, such calibration, e.g., correction, to it can be applied whenever, e.g., there is no restriction on order or timing for employing the first and second calibration values.

The present invention also relates to a device configured for determining at least one property of a sample and comprising a micromechanical sensor having an apex. The device comprises a first quantity obtaining module, a second quantity obtaining module, a first calibration value providing module, a second calibration value providing module and a sample property determination module. The first quantity obtaining module is configured for obtaining a first quantity indicative of a response of the micromechanical sensor due to an apex-sample-interaction. The second quantity obtaining module is configured for obtaining a second quantity indicative of a response of the micromechanical sensor due to a local actuation force acting locally on or in the micromechanical sensor. The first calibration value providing module is configured for providing at least one first calibration value for calibrating, e.g., correcting the first quantity, the at least one first calibration value being configured for causing a change to one or more determined positions of the apex in the response of the micromechanical sensor due to the apex-sample-interaction. The second calibration value providing module is configured for providing at least one second calibration value for calibrating, e.g., correcting the second quantity, the at least one second calibration value being configured for causing a change to one or more determined positions of the apex in the response of the micromechanical sensor due to the local actuation force acting locally on or in the micromechanical sensor. Moreover, the sample property determination module is configured for determining the at least one property of the sample based on the obtained first quantity, the obtained second quantity, the provided at least one first calibration value and the provided at least one second calibration value.

The device can be used for carrying out the method for determining at least one property of a sample as described herein. The device can be part of an atomic force microscope or may itself be an atomic force microscope. Accordingly, the present invention also relates to an atomic force microscope comprising or being the device described herein.

The first quantity obtaining module, second quantity obtaining module, first calibration value providing module, second calibration value providing module, and sample property determination module may be separate modules or may form a unit for performing the different functions. It is also possible that a combination of some of the modules, e.g., the first quantity obtaining module and the second quantity obtaining module, form a combined module, such as e.g., a quantity obtaining module. Some or all modules may be implemented as software modules or hardware modules, e.g., field programmable gate arrays (FPGA), application specific integrated circuit (ASIC), or any other specialized circuit.

The present invention also relates to a computer program for determining at least one property of a sample, the computer program including instructions for executing the steps of the method for determining at least one property of a sample as described herein, e.g. according to at least one of the claims 1 to 12 or any embodiment thereof, when run on a processor. Furthermore, the present invention relates to a non-transitory computer readable data medium storing the computer program for determining at least one property of a sample as described herein.

Additional and non-limiting further explanations of terms and expressions used herein are provided in the following.

Herein, "obtaining" such as "obtaining a first quantity" or "obtaining a second quantity" may include measuring, acquiring, collecting, recording, e.g., using an experimental setup, generating by a module, providing, retrieving, deriving a previously stored quantity, e.g., which has been either measured or derived by a model, or the like.

Herein, the "at least one property of a sample" may be determined based on the obtained first quantity calibrated, e.g., corrected, by the at least one first calibration value and the obtained second quantity calibrated, e.g., corrected, by the at least one second calibration value. For example, the at least one property of a sample may be determined based on the first quantity as a function of the second quantity which may define a quantity of the sample that shall be determined, e.g., a property of the sample. The at least one property of a sample may be a mechanical, an electrical, a magnetic property or the like and in particular a nanomechanical, a nanoelectrical, a nanomagnetic property or the like. Preferably, the property of the sample is determined with nanometre resolution. The at least one property may, for example, be a topography of the sample surface, an adhesion strength, an electrical resistance, a conductivity, a dielectric strength, a magnetic force, a magnetic susceptibility, a magnetization of the sample, or any other mechanical, electrical, or magnetic property of the sample.

Herein, the "micromechanical sensor" may be a cantilever, a membrane or the like. The micromechanical sensor has an apex, e.g., a probe tip. It is also possible that the apex is realised using a microbead attached to the micromechanical sensor. The apex is used to probe the sample by means of mechanical contact with the sample. That is, e.g., for topographic imaging, the apex may be raster scanned over the sample. From experimental data indicative of the mechanical interaction of the apex with the surface of the sample, the surface topography of the sample can be derived. To this end, the apex may be brought into contact with the sample, and the sample is raster scanned along an x-y grid. An electronic feedback loop may be implemented to keep the probe-sample force constant during scanning. This feedback loop may have a micromechanical sensor deflection as input, and its output may control the distance between the apex and the sample along the z-axis. Since the apex, preferably, remains at least intermittently or transiently in contact, e.g., at least in intermittent or transient mechanical contact, with the sample while scanning in the x-y plane, height variations in the sample may cause a deflection of the micromechanical sensor. The apex may also be continuously in contact, e.g., in continuous mechanical contact, with the sample while scanning in the x-y plane and height variations in the sample may cause a deflection of the micromechanical sensor. With the feedback loop, the position of the micromechanical sensor, e.g., z-position or the apex-sample distance, may be adjusted so that the deflection is restored to a predefined value. For example, the feedback loop may adjust the apex-sample distance continuously during a scanning motion such that a deflection remains approximately constant. Thereby, the feedback output may approximately equal the sample surface topography so that a surface topography of the sample may be determined.

Herein, a position of the apex may refer to any predefined point on the apex that may be used for defining a position. For example, a position of the apex may be the position at a tip of the apex. However, it is also possible that a position of the apex is associated with a central or top position on the apex. Depending on the resolution used for defining the position of the apex, also the complete apex may be used for defining the position of the apex. Generally, in case of a solid apex, from a known, e.g., determined or measured, position of the apex, any other position on the apex can be derived in case the geometry of the apex is known. The position of the apex may be a relative position of the apex to the sample, e.g., a z-position may be the apex-sample-distance.

Herein, a "micromechanical sensor readout" preferably, is indicative of a deflection of the micromechanical sensor, e.g. measured via optical beam deflection. Yet, it is also possible that a micromechanical sensor readout is indicative of a bending or other deformation of the micromechanical sensor, e.g., measured via a piezo-resistive element embedded in or on the micromechanical sensor.

Herein, the "first quantity" is indicative of a response of the micromechanical sensor due to an apex-sample-interaction. A response of the micromechanical sensor due to an apex-sample-interaction may be an apex position deflection that may be determined, e.g., while exerting a force or bending moment onto the micromechanical sensor for varying an apex-sample distance. In particular, the first quantity may correspond to a time dependent position function of the apex which may be derived from a measured angular function of the apex while being at least transiently or intermittently in contact with a sample surface, preferably, in one excitation cycle, e.g., of pulsed photothermal excitation. In particular, the first quantity may be determined by subtraction of the second quantity indicative of a free micromechanical sensor deflection from a measured micromechanical sensor deflection with intermittent surface contact represented by collected experimental data, e.g., while scanning the sample along an x-y grid.

It is possible to change the apex-sample-interaction by inducing an asymmetric expansion or contraction of the micromechanical sensor. That is, it is possible that the first quantity is determined based on a change of a bending moment shape in the micromechanical sensor caused by the exertion of the force. In particular, the first quantity may be an angular function representing a contacting of the micromechanical sensor with the sample. Accordingly, measuring a first quantity indicative of a response of the micromechanical sensor due to an apex-sample-interaction may be performed by determining a contact of the micromechanical sensor with the sample. Thus, it is preferred that the first quantity is derived when the apex is at least transiently in contact with the sample. The first quantity may be associated with a response of the micromechanical sensor caused by the contacting with the sample. A response of the micromechanical sensor due to an apex-sample-interaction may be a deflection or other interactions such as a frequency response, damping, or the like. The first quantity may be measured based on optical beam deflection, which measures the angle of a micromechanical sensor. Further ways of obtaining the first quantity may be based on a strain sensor, e.g., in a self-sensing cantilever, which measures strain of the self-sensing cantilever. Also, other detection schemes, e.g., that measure a position on the micromechanical sensor that does not directly correspond to the position of the apex may also be employed. A measurement of the first quantity may be averaged over the oscillation cycle of the micromechanical sensor and thereby not necessarily provide an instantaneous position measurement or a measurement that directly corresponds to the apex position in closest proximity to the sample, e.g., a shortest distance between a distal end of the apex to the surface of the sample.

Herein, the "second quantity" may be indicative of a response of the micromechanical sensor due to a local actuation force acting locally on or in the micromechanical sensor. In particular, the second quantity may be an angular function determined when the micromechanical sensor is without contact to the surface of the sample, e.g., for a free swinging or unperturbed micromechanical sensor. In particular, the second quantity may correspond to a time dependent position function of the apex, which is derived based on the angular function of the device without contact to the sample. Preferably, thus, the second quantity is derived when the apex is not in contact with the sample. Measuring the second quantity indicative of a response of the micromechanical sensor due to a local actuation force acting locally on or in the micromechanical sensor can be performed, for example, using optical beam deflection, a strain sensor, e.g., in a self-sensing cantilever or other detection schemes, e.g., that are also suitable for obtaining the first quantity. Preferably, the second quantity is used for obtaining the first quantity. That is, it is preferred that experimental data indicative of an intermittent deflection of the micromechanical sensor are collected while the micromechanical sensor is at least transiently in contact with the sample. Furthermore, the second quantity is obtained by measuring an angular deflection of the micromechanical sensor while the micromechanical sensor is not in contact with the sample, e.g., free swinging. The first quantity may be obtained by subtracting the obtained second quantity from the measured intermittent deflection of the micromechanical sensor.

Herein, the "local actuation force acting locally on or in the micromechanical sensor" may be induced using a photothermal excitation laser, but also through heating due to local electrical current, and/or piezo-electric actuation. In particular, the local actuation force can be induced employing a method that yields bending the sensor via an asymmetric expansion or contraction. Photothermal excitation is a preferred embodiment to achieve this.

Herein, a "quantity" may be one or more values measured over time or, in other words, a function that may depend on time.

Herein, a "calibration" may be a calibration of a deflection measurement for a given bending shape of the micromechanical sensor, e.g., to yield a measure of changes in the micromechanical sensor position, e.g., the apex position, due to changes in an apex-sample interaction. In particular, the different calibrations may include different calibrations for extracting the apex-sample distance from the local actuation force dependent response and the response based on the apex-sample interaction. A calibration correction of the change in bending moment based on a determined bending of the micromechanical sensor may, preferably, be accomplished via a bending-shape dependent calibration correction such as an amplitude and/or phase correction. Preferably, a bending-shape dependent calibration correction is configured to determine an apex-sample distance. A bending-shape dependent calibration correction such as an amplitude and/or phase of the change in bending moment based on the determined bending of the micromechanical sensor, preferably, is configured to relate changes in the micromechanical sensor deflection to changes in apex-sample distance due to the force.

Herein, the "first calibration value" may be configured for causing a change to one or more determined positions of the apex in the response of the micromechanical sensor due to the apex-sample-interaction. In particular, the first calibration value may represent one or more values that may be used to convert a micromechanical sensor response into changes in a position of the apex. That is, the first calibration value may account for the interaction between the apex of the micromechanical sensor and the sample. The first and second calibration value may differ, e.g., in amplitude and/or in phase.

Herein, the second calibration value may be configured for causing a change to one or more determined positions of the apex in the response of the micromechanical sensor due to the local actuation force acting locally on or in the micromechanical sensor. In particular, the second calibration value may be determined from the forces acting on the micromechanical sensor without apex-sample interactions. In particular, the second calibration value may be provided based on the apex-sample distance which accounts for the forces acting on the micromechanical sensor excluding the interaction between the apex of the micromechanical sensor and the sample. The at least one second calibration value may be a phase correction and/or an amplitude correction, e.g., to the at least one first calibration value. The phase correction may be configured for correcting a phase shift associated with the second quantity. With the second calibration value, it may be possible to correct for a difference in an apparent and an actual position that may arise due to time lag of an actuation process, which may cause bending forces or bending moments to evolve along the micromechanical sensor over the actuation cycle. The at least one second calibration value may be applied to the at least one first calibration value such that a combined calibration value may be applied for calibrating a measurement.

The devices and methods described herein can be used for probing one or more of mechanical, electrical or magnetic properties of a sample at nanometre resolution. Samples may be solid state samples such as semiconductor samples or the like. The devices and methods described herein, can also be used to probe soft and biological samples such as proteins, living cells, virus capsids or the like.

It shall be understood that the aspects described above, and specifically the method of claim 1, the device of claim 13 and the computer program of claim 14, have similar and/or identical preferred embodiments, in particular as defined in the dependent claims.

It shall be understood that a preferred embodiment of the present invention can also be any combination of the dependent claims or above embodiments with the respective independent claim.

These and other aspects of the present invention will be apparent from and elucidated with reference to the embodiments described hereinafter.

BRIEF DESCRIPTION OF THE DRAWINGS

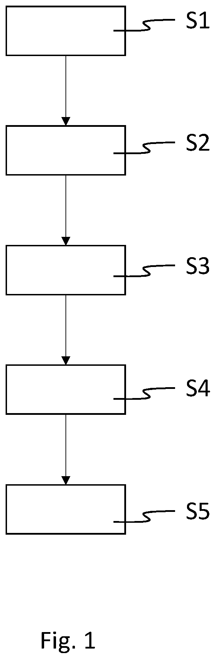

Fig. 1 :   shows a flowchart representing a method for determining at least one property of a sample with a device that comprises a micromechanical sensor having an apex;

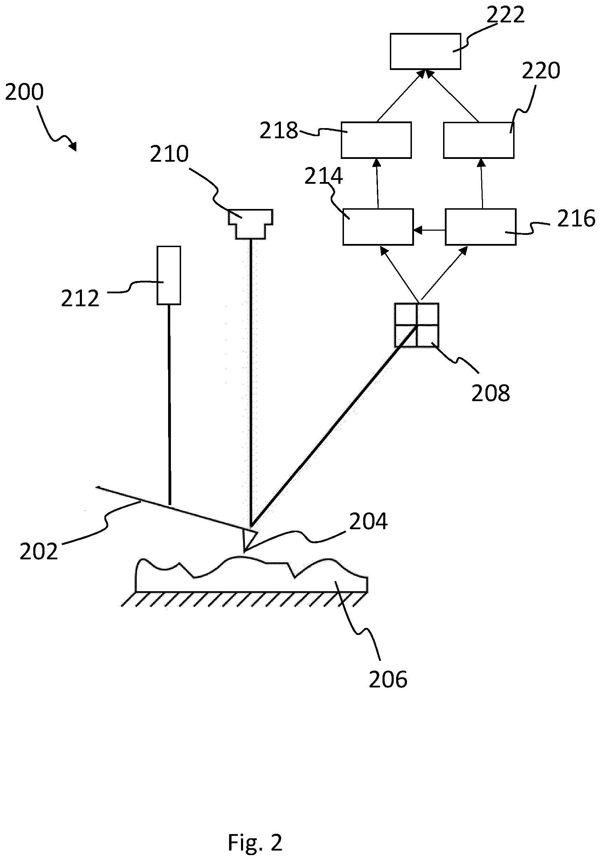

Fig. 2:   schematically and exemplarily shows a device for determining at least one property of a sample;

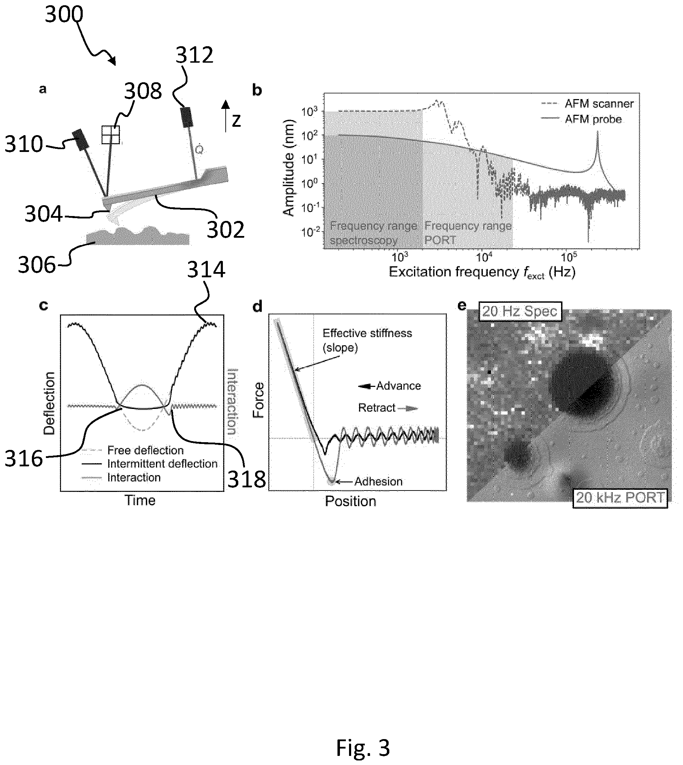

Fig. 3:   shows in (a), a schematic of a device for photothermal off-resonance tapping (PORT), in (b), a plot demonstrating the velocity advantage of the photothermal excitation of the micromechanical sensor, in (c), curves of photothermal off-resonance tapping deflection versus time signals with and without intermittent surface contact, and the interaction force derived from the difference, in (d), a force versus position curve reconstructed from photothermal off-resonance tapping signals using the interaction as force and free deflection as position, and in (e), an effective stiffness map of a polymer blend;

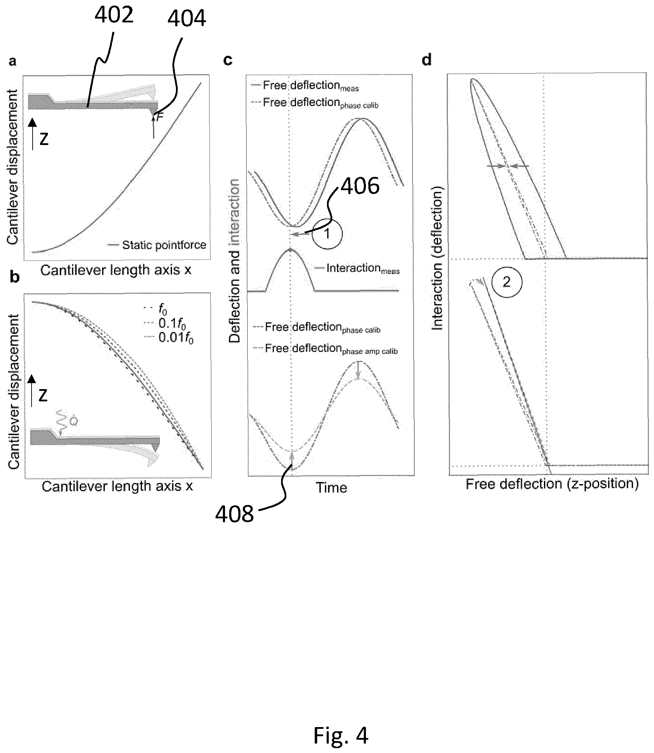

Fig. 4:   shows in (a), a schematic of a micromechanical sensor deformed by a point force at the apex (top) representing apex-sample interactions and by a heat source at the base (bottom) representing photothermal excitation, in (b), finite element method simulations of a thermally excited micromechanical sensor beam showing that its bending shape changes with excitation laser spot position and excitation frequency as depicted in (c) and (d);

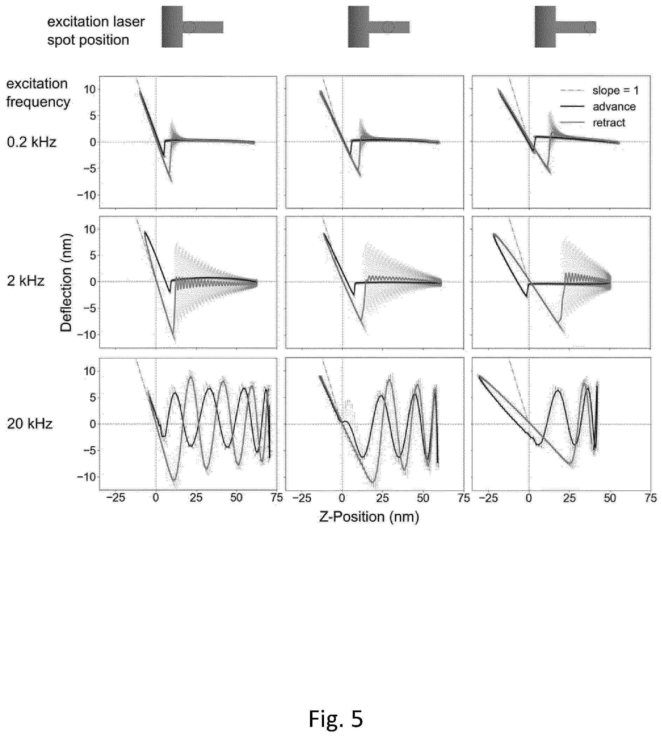

Fig. 5:   shows incompletely calibrated deflection-z-position curves obtained in photothermal off-resonance tapping on a hard sapphire surface for excitation laser spot positions at base, centre and apex end of the micromechanical sensor with excitation frequencies of 0.2 kHz, 2 kHz and 20 kHz using a WM0.8PTD micromechanical sensor; and

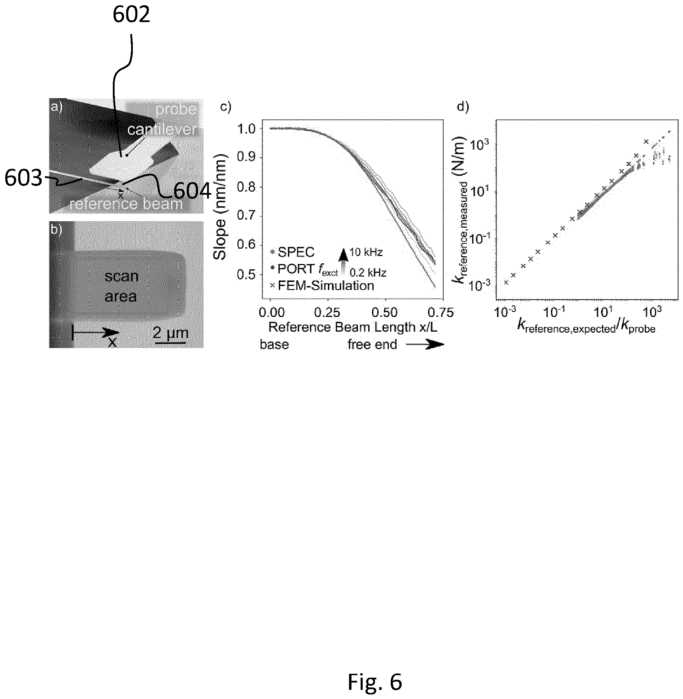

Fig. 6:   shows in (a), a render showing the arrangement of the micromechanical sensor (WM0.8PTD, Nanosurf AG) and a reference sample in form of a reference beam (USC-f1.5-k0.6, Nanoworld AG) for measuring a stiffness profile of the reference beam along its length axis x, in (b), a scanning electron microscopy (SEM) image showing the planar dimensions of the reference beam (7 $\mu$m x 3 $\mu$m) with indicated scan range, in (c), a measured slope of the in contact part of the obtained force curves along the normalized length axis x of the reference beam for different excitation frequencies using photo-thermal off-resonance tapping and spectroscopy and in (d) a measured and simulated sample stiffness versus expected stiffness.

DETAILED DESCRIPTION OF EMBODIMENTS

Figure 1 shows a flowchart representing a method for determining at least one property of a sample with a device that comprises a micromechanical sensor having an apex. The sample can be a solid state or soft matter or biological sample. For example, the sample may be an electronic, photonic, or optoelectronic device or an intermediate product thereof. The sample may also be a biological sample such as a protein, a living cell, a virus capsid or the like. The device, e.g., may be an atomic force microscope and the micromechanical sensor may be a cantilever or membrane having an apex, e.g., in form of a probe tip.

In the method, a first quantity indicative of a response of the micromechanical sensor due to an apex-sample-interaction is obtained (step S1). Therefore, the apex of the micromechanical sensor, e.g., the probe tip of a cantilever, is brought at least into transient or intermittent contact with a surface of the sample while probing the surface, e.g., actuating the micromechanical sensor. In this embodiment the micromechanical sensor is actuated due to a local actuation force acting locally on or in the micromechanical sensor, e.g., using photothermal excitation. The first quantity may be indicative of a deflection of the apex of the micromechanical sensor. For example, the first quantity may be obtained using a readout laser and a position detector configured for measuring an angular deflection of the micromechanical sensor, e.g., based on optical beam deflection while the micromechanical sensor is at least in transient or intermittent contact with the sample. In this embodiment, the first quantity is a time-dependent angular function indicative of the deflection of the micromechanical sensor when it is at least in transient contact with the sample. The first quantity includes at least one full micromechanical sensor deflection cycle induced by the excitation due to the local actuation force acting locally on or in the micromechanical sensor inducing a bending of the micromechanical sensor such that the apex of the micromechanical sensor at least transiently contacts the surface of the sample. The deflection of the micromechanical sensor is dampened, such that it is reduced over time until the next excitation pulse is initiated.

Furthermore, a second quantity is obtained (step S2). The second quantity is indicative of a response of the micromechanical sensor due to a local actuation force acting locally on or in the micromechanical sensor. The local actuation force may be induced by means of a photothermal excitation laser that induces local photothermal excitation at a selected position on the micromechanical sensor at a predefined frequency. The heat induced at the predefined frequency causes bending of the micromechanical sensor. The second quantity can also be obtained using a readout laser and a position detector based on optical beam deflection while the micromechanical sensor is not in contact with the sample, e.g., free-swinging. In this embodiment, the second quantity is a time-dependent angular function indicative of the deflection of the micromechanical sensor when the micromechanical sensor is not in contact with the sample. The second quantity includes at least one full micromechanical sensor deflection cycle induced by the excitation due to the local actuation force acting locally on or in the cantilever inducing a bending of the micromechanical sensor such that the micromechanical sensor and its apex swing freely.

In this embodiment, the selected position on the micromechanical sensor for the photothermal excitation is identical for performing steps S1 and S2. Yet, before the first quantity is obtained, it is generally preferred that experimental data, e.g., raw data indicative of an intermittent deflection caused by the apex interaction with the sample are acquired. The first quantity may then be determined by subtracting the second quantity from the raw data indicative of an intermittent deflection.

When probing a sample, a total bending of the micromechanical sensor is caused by an apex-sample interaction, which, for a cantilever, is normal point-force micromechanical sensor beam bending that may be described by Euler-Bernoulli beam equations, and in addition, micromechanical sensor modulation actuation caused by the local actuation force, which may have some combination of bending force and bending moment distributed along the micromechanical sensor. The total bending may thus result from a superposition of the bending caused by apex-sample interaction and the bending caused by the local actuation force.

For calibrating, e.g., correcting, the first quantity, at least one first calibration value is provided (step S3). The at least one first calibration value is configured for causing a change to one or more determined positions of the apex in the response of the micromechanical sensor due to the apex-sample-interaction. The at least one first calibration value is obtained for the situation in which the apex of the micromechanical sensor experiences a force from the sample, e.g., if it contacts the sample.

The first calibration value may be obtained, for example, by pressing the apex of the micromechanical sensor against a hard surface of the sample or a reference sample. Therefore, a piezo actuator, e.g., z-scanner that is part of the xyz-scanner or nanopositioner of the atomic force microscope can be used. A displacement of the mechanical sensor can be calibrated against a movement of the piezo actuator. Alternatively, the first calibration value is obtained by treating the response of the micromechanical sensor as a harmonic oscillator of a given stiffness and comparing its response to thermal noise with predictions from thermal physics.

Furthermore, for calibrating, e.g., correcting, the second quantity, at least one second calibration value is provided (step S4). The at least one second calibration value is configured for causing a change to one or more determined positions of the apex in the response of the micromechanical sensor due to the local actuation force acting locally on or in the micromechanical sensor. It is particularly preferred that the at least one second calibration value includes a phase correction and/or an amplitude correction which can be determined experimentally and/or by employing a simulation such as a finite element method simulation based on the geometry of the micromechanical sensor. The at least one second calibration value is obtained for the situation in which the apex of the micromechanical sensor is not in contact with the sample but swings freely.

In particular, bending motion caused by a local actuation force and without surface interaction typically is cyclic. Difference in apparent and actual position of the apex, here the z-position corresponding to the direction of distance between the tip and the sample, may be characterized by a phase shift and an amplitude difference. Assuming small motions compared with overall geometry of the micromechanical sensor, the interaction can be treated as a linear system. If the locally acting force result in a nonlinear behaviour, there may be frequency-dependent phase and amplitude corrections.

Subsequently, in the method, the at least one property of the sample is determined (step S5). In particular, for determining the at least one property, the obtained first quantity, the obtained second quantity, the provided at least one first calibration value and the provided at least one second calibration value are employed. In this embodiment, for example, the topography of the sample is determined by scanning the micromechanical sensor along an x-y grid over the sample surface to collect experimental data indicative of an intermittent deflection of the micromechanical sensor. Furthermore, the second quantity is obtained by measuring a response, e.g., a deflection, of the micromechanical sensor due to a local actuation force acting locally on or in the micromechanical sensor while the micromechanical sensor is swinging freely. For obtaining the first quantity, the second quantity may be subtracted from the experimental data. Afterwards the first and second quantities can be calibrated, e.g., corrected, using the at least one first and at least one second calibration values. For example, the first quantity may be a function of the second quantity and may be corrected by using the at least one first and at least one second calibration values. This may be achieved by plotting the first quantity as a function of the second quantity to cause a change to one or more determined positions of the apex in the response of the micromechanical sensor due to the apex-sample-interaction and to cause a change to one or more determined positions of the apex in the response of the micromechanical sensor due to the local actuation force acting locally on or in the micromechanical sensor, respectively. The resulting corrected data may then be indicative of the topography of the sample and include information of the mechanics and/or electrostatics and/or magnetism of the sample. For example, from a resulting force-distance curve, the topography of the sample may be derived.

It is also possible that the response of the micromechanical sensor is analysed at each deflection cycle, e.g., oscillation cycle, of the micromechanical sensor. The response of the micromechanical sensor may be compared with a setpoint response, e.g. setpoint response value, and a difference between the response and the setpoint response may be used as an error input into a feedback controller. The feedback controller may move the position, e.g. z-position, of the apex of the micromechanical sensor, e.g. using the piezo actuator, to adjust an average apex-sample distance. The setpoint response may take several different forms, for example an instantaneous sensor response value, or an average amplitude of micromechanical sensor response over an entire oscillation cycle, several oscillation cycles or a part of an oscillation cycle. Moreover, for each xy position on the surface of the sample, the first quantity may be plotted against the second quantity to derive, for example, a force versus z-position, e.g., the apex-sample-distance. From such an analysis of such curves, mechanical, electrical, and/or magnetic properties of the surface of the sample may be derived.

Figure 2 schematically and exemplarily shows a device 200 for determining at least one property of a sample 206. In particular, the device 200 is configured for probing the at least one property of the sample 206 with nanometre resolution. The device 200 can be used for conducting the method described with reference to Figure 1. The device 200 may be or may be part of an atomic force microscope.

The device 200 comprises a micromechanical sensor 202 having an apex 204 for mechanically probing the sample 206. Furthermore, the device 200 has a position detector 208 and a readout laser 210 for detecting an angular deflection of the micromechanical sensor 202. Moreover, the device 200 has a photothermal excitation laser 212 for inducing a local actuation force that causes bending of the micromechanical sensor 202.

With the device 200, the micromechanical sensor 202 is used to probe both, apex-sample interactions as well as an apex-sample distance. It is a particular advantage of the device 200 that both, the apex-sample interactions and the apex-sample distance are calibrated separately and differently. This allows to accurately obtain apex-sample interaction forces as a function of an apex-sample distance with the device 200.

To this end, the device 200 comprises a first quantity obtaining module 214, a second quantity obtaining module 216, a first calibration value providing module 218 and a second calibration value providing module 220. The first quantity obtaining module 214 is configured for obtaining a first quantity indicative of a response of the micromechanical sensor 202 due to an apex-sample-interaction. For example, for obtaining a first quantity, the first quantity obtaining module 214 may use a deflection readout from the position detector 208 and a readout laser 210, e.g., based on optical beam deflection. Furthermore, for obtaining a first quantity, the first quantity obtaining module 214 may use the second quantity obtained by the second quantity obtaining module 216. For example, the deflection readout from the position detector 208 may be indicative of an intermittent deflection of the micromechanical sensor 202, thus, when the micromechanical sensor 202 is contacting the sample 206. The first quantity, preferably, is thus determined with the first quantity obtaining module 214 based on contacting of the apex 204 onto a hard surface of the sample 206 such that it is at least in transient contact with the surface of the sample 206. Furthermore, the obtained second quantity indicative of a response of the micromechanical sensor 202 due to a local actuation force acting locally on or in the micromechanical sensor 202 may be subtracted from the intermittent deflection of the micromechanical sensor 202 to obtain the first quantity. To this end, the second quantity obtaining module 216 is configured for obtaining a second quantity indicative of a response of the micromechanical sensor 202 due to a local actuation force acting locally on or in the micromechanical sensor 202. The second quantity, preferably, is determined with the second quantity obtaining module 216 from a deflection readout from the position detector 208 when the micromechanical sensor 202 is free swinging or unperturbed, e.g., without contact to the sample 206. The local actuation force acting locally on or in the micromechanical sensor 202 may be induced by a laser beam of the photothermal excitation laser 212 focused on a surface of the micromechanical sensor 202. As an alternative or in addition to actuating the micromechanical sensor 202 with the photothermal excitation laser 212, the device 200 may comprise means for applying a local electrical current, for piezo-electric actuation, magnetic actuation, electric actuation or the like to induce the local actuation force in the micromechanical sensor 202.

With the first calibration value providing module 218, at least one first calibration value can be provided for calibrating, e.g., correcting, the first quantity. The at least one first calibration value is configured for causing a change to one or more determined positions of the apex 204 in the response of the micromechanical sensor 202 due to the apex-sample-interaction. With the second calibration value providing module 222, at least one second calibration value can be provided for calibrating, e.g., correcting, the second quantity. The at least one second calibration value is configured for causing a change to one or more determined positions of the apex 204 in the response of the micromechanical sensor 202 due to the local actuation force acting locally on or in the micromechanical sensor 202. It is preferred that the at least one second calibration value is determined by the second calibration value providing module 220 as a phase correction and/or an amplitude correction to the at least one first calibration value.

Thus, with the first calibration value providing module 218 and the second calibration value providing module 220, it is possible to employ different calibrations to extract changes in apex position due to apex-sample interactions and due to the local actuation force acting locally on or in the micromechanical sensor 202 to change the apex-sample distance. With the device 200, it is thus possible to calibrate the change in bending due to the apex-sample forces differently from the bending induced by the change in bending moment due to the local actuation force acting locally on or in the micromechanical sensor 202, where the latter bending be determined under conditions where the apex-sample forces are negligible, at a suitable distance from the sample. Thereby, it is possible with the device to accurately obtain apex-sample interaction forces as a function of an apex-sample distance and to accurately determine the at least one property of the sample. Accordingly, the sample property determination module 222 is configured for determining the at least one property of the sample based on the obtained first quantity, the obtained second quantity, the provided at least one first calibration value and the provided at least one second calibration value. Specifically but not exclusively, the first quantity may be plotted against the second quantity to derive a force as a function of apex position with respect to the sample, and thereby infer mechanical, electrical or magnetic properties of the sample.

Figure 3 shows in Figure 3(a), a schematic of a device 300 for photothermal off-resonance tapping. The device 300 comprises a micromechanical sensor 302 having an apex 304 for probing a sample 306. Furthermore, the device 300 comprises a position detector 308 and readout laser 310 to monitor the micromechanical sensor's deflection, while a second modulated laser 312 excites the micromechanical sensor 302, e.g., the second modulated laser 312 induces a local actuation force in the micromechanical sensor 302 such that it is actuated. Figure 3(b) shows an amplitude over excitation frequency graph for a piezo scanner (AFM scanner) and the micromechanical sensor 312 (AFM probe)Figure 3(c) shows photothermal off-resonance tapping deflection versus time signals with and without intermittent or transient surface contact, and the interaction force derived from the difference. Figure 3(d) shows a force versus position curve reconstructed from photothermal off-resonance tapping signals using the interaction as force and free deflection as position. Figure 3(e) shows an effective stiffness map ($10 \times 10$ $\mu m^2$) of a polymer blend (SBS-PS) showing that photothermal off-resonance tapping (20 kHz pixel rate, 500 px x 500 px, 1 min; shown below the diagonal on the bottom right) offers a speed advantage compared to spectroscopy (1 Hz pixel rate, 60 px x 60 px, 1 h; shown above the diagonal on the top left) while still maintaining the contrast.

Still referring to Figure 3, for photothermal excitation, a photothermal excitation laser 312 may be focused on the micromechanical sensor 302 in addition to the laser beam of a readout laser 310 used for micromechanical sensor deflection readout as shown in Figure 3(a). An advantage of photothermal off-resonance tapping is a comparatively large speed. In difference to the measurement of classical force distance curves, the probe-sample distance may be varied through direct micromechanical sensor actuation via photo-thermal actuation. Conventionally, the piezo scanner is moved in z-direction for changing apex-sample distance. Since a micromechanical sensor has typically a much higher mechanical resonance frequency $f_0$ than a piezo scanner shown in Figure 3(b), much higher excitation frequencies are possible with direct micromechanical sensor excitation without adding significant effects of the actuator ringing on the measured force or distance. A higher excitation frequency may result in acquisition of more force-distance curves per time allowing for faster scanning, e.g., which enables higher resolution or more frames for a given time. By using photothermal excitation, a wide selection of probes is available, since the main driving mechanism is the bimorph effect and various micromechanical sensors featuring a reflective metal coating are suitable. When increasing the excitation laser intensity, the micromechanical sensor 302 bends due to induced stress by heat expansion. In the absence of apex-sample forces, e.g., if the apex 304 of the micromechanical sensor 302 is not in contact with the sample 306, the micromechanical sensor deflection may follow a sinusoidal movement when excited with a sinusoidal laser intensity signal.

When the apex 304 is in intermittent or transient contact with the sample 306, the micromechanical sensor 302 deflects due to apex-sample forces shown in the signal 314 based on experimental data measured with the apex 304 in intermittent contact with the sample 306. Signal 316 corresponds to the second quantity and shows the free deflection curve over time of the micromechanical sensor 302 when the apex 304 is not in contact with the sample 306. Through the subtraction of the free micromechanical sensor deflection 316, e.g., the second quantity, from the micromechanical sensor deflection 314 with intermittent surface contact, e.g., the measurement data as measured for the apex 304 in transient contact with the sample 306, the apex-sample interaction force signal 318 corresponding to the first quantity, can be reconstructed as shown in Figure 3(c). Using the micromechanical sensor deflection without surface contact derived from the second quantity as height position, e.g., z-position, and the interaction signal derived from the first quantity as force, the signals can be transformed to a force-position curve as depicted in Figure 3(d). Using the deflection with intermittent surface contact as apex-sample separation, the signals can be transformed to a force-distance curve.

By fitting contact mechanic models to the indentation part of the force-distance curve, it is possible to obtain the sample elasticity. An elasticity map of a Styrene-Butadiene-Styrene-Polystyrene polymer blend (SBS-PS) measured using photothermal off-resonance tapping and piezo-driven spectroscopy is shown in Figure 3(e). Using photothermal off-resonance tapping, it may be possible to measure at an approximately 100 times higher pixel rate compared to conventional spectroscopy and about 10 times higher compared to piezo-driven off-resonance tapping while still maintaining the same stiffness contrast. This speed advantage may enable a significantly higher measurement resolution at shorter time scales. However, to achieve quantitative force-distance measurements using photothermal micromechanical sensor excitation and optical beam deflection readout, some correction is necessary which will be exemplary explained in the following. In particular, in the following, an embodiment of the method according to the present invention is explained for accurately acquiring force-distance curves with photothermal off-resonance tapping by aligning the apparent apex position with the actual apex displacement.

Turning to Figure 4, photothermal off-resonance tapping allows a free choice of excitation laser spot position and excitation frequency, limited by presence of resonance effects in the contact part appearing at approximately $f_{exct} > 0.1f_0$. Excitation position and frequency may affect the dynamics of a thermal wave inside the micromechanical sensor 402 and hence the bending of the micromechanical sensor 402. Since the micromechanical sensor's apex end deflection may be used to calculate the apex-sample distance and the force acting at the apex (see formulas 1 to 4 depicted below), a thermodynamically induced change in deflection behaviour may influence the obtained force-distance curves. The excitation location and frequency dependent micromechanical sensor bending shapes as simulated using a 2D finite element model (FEM) are visualized in Figure 4(a). The simulation shows that the micromechanical sensor angular deflection depends on the actuation frequency and generally appears to be different from a situation in which the micromechanical sensor is driven by a local actuation force acting on the free end. Hence, the measured apex displacement generally appears different from the actual apex displacement. Moreover, the maximum force peak of the interaction signal is shifted in relation to the minimum peak of the free micromechanical sensor deflection signal used as height position, e.g., z-position relative to a sample, as can be seen in Figure 4(b). In the force-distance curve, this shift appears as force hysteresis in the in-contact part of the curve, which can be seen in Figure 4(c) and the fitted Young's modulus does not match the value of the sample elasticity anymore. For compensation, at least one first calibration value and at least one second calibration value is introduced. For example, the at least one second calibration value may include a phase shift correction 406 and an amplitude correction 408 in form of a slope scaling correction factor, as disclosed in Figure 4(c). To correct the phase lag, the free deflection is shifted in time to align its minimum with the maximum peak of the interaction signal on a surface, e.g., in contact with the sample. This shift eliminates the hysteresis in the force-distance curve. For a correction of the frequency dependent amplitude excitation efficiency, the free deflection is scaled by multiplication with a factor obtained from a force-position curve measurement on a hard surface, e.g., in contact with the sample, using photothermal off-resonance tapping to match a slope of -1 nm/nm in the in-contact part of the curve.

$$z\_position[m] = deflection_{free}[V] * \sigma_s[\tfrac{m}{V}] \tag{1}$$

$$interaction[m] = deflection_{tap}[V] - deflection_{free}[V] * \sigma_s[\tfrac{m}{V}] \tag{2}$$

$$TSS[m] = z\_position[m] + interaction[m] \tag{3}$$

$$interaction[N] = interaction[m] * k[\tfrac{N}{m}] \tag{4}$$

$$z\_position_{corr}[m] = deflection_{free,shift}\ \ [V] * a_{corr}[\ ] * \sigma_s\left[\tfrac{m}{V}\right] \tag{5}$$

$$TSS_{corr}[m] = z\_position_{corr}[m] + interaction[m] \tag{6}$$

Figure 5 shows deflection-z-position curves obtained in photothermal off-resonance tapping on a reference sample in form of a hard sapphire surface for excitation laser spot positions at base, centre and apex end with excitation frequencies of 0.2 kHz, 2 kHz and 20 kHz using a micromechanical sensor in form of a WM08.PTD of Nanosurf AG. The single measurements with 2500 curves per dataset are shown as light grey points while the averaged curves are shown in red in colour drawings and grey in greyscale drawings, and black. On a hard surface no sample indentation is expected, which results in a slope of 1 nm/nm for the in-contact part of the curve.

Still referring to Figure 5, the second calibration values in form of correction factors to the first calibration values for a given excitation position and frequency may be obtained, e.g., from a photothermal off-resonance tapping measurement on a hard surface or from a finite element method simulation. For Figure 5, the correction factors for a micromechanical sensor in form of a WM0.8PTD cantilever were determined in simulation and experiment. The WM0.8PTD of Nanosurf AG is a cantilever with about 50 $\mu$m length, 20 $\mu$m widths near the apex, a resonance frequency of about 250 kHz in air and a spring constant of about 0.8 N/m. The measurement was conducted on a hard surface, e.g., a sapphire wafer, for excitation frequencies at 0.2, 2 and 20 kHz and excitation laser spot positions at base (left drawings in Fig. 5), centre (middle drawings in Fig. 5) and apex end (right drawings in Fig. 5) of the micromechanical sensor. Ideally, when probing micromechanical sensor deflection against z-position on a hard surface 1 nm of movement in height, e.g., z-position, causes 1 nm deflection of the micromechanical sensor since no indentation is expected on the hard surface. The slope of the in-contact part of the curve is then -1 nm/nm. Low excitation frequencies, e.g., of 200 Hz/0.1%$f_0$, introduced at the micromechanical sensor base may yield a slope of approximately -1 nm/nm.

Introducing the excitation at the same low excitation frequency further to the apex end may introduce a stronger angular deflection for a given displacement. This may result in overestimating the true displacement by measuring with optical beam deflection readout, which in time may let the minimum of the free wave shift to the left side of the interaction peak and may give an inverted hysteresis in the force-distance curve.

Introducing a faster excitation, e.g., of 2 kHz/1%$f_0$, at the base may cause a lower angular deflection for a given displacement. This may result in underestimating the true displacement with optical beam detection, which in time may let the minimum of the free wave shift to the right side of the interaction peak and may give a hysteresis in the force-distance curve.

Exciting at frequencies >10%$f_0$ in air without strong damping may not vanish the snap-out ringing completely within one oscillation cycle, so in-contact ringing may be present in the in-contact part of the force curve.

Figure 6(a) depicts a render showing the arrangement of a micromechanical sensor 602 (WM0.8PTD, Nanosurf AG) with apex 604 and a reference beam 603 (USC-f1.5-k0.6, Nanoworld AG) for measuring a stiffness profile of the reference beam along its length axis x. The micromechanical sensor 602 was scanned along the reference beam in force distance spectroscopy at 50 Hz scanner excitation and in photothermal off-resonance tapping at excitation frequencies between 200 Hz - 10 kHz. Figure 6(b) shows a scanning electron microscopy (SEM) image showing the planar dimensions of the reference beam (7 $\mu$m $\times$ 3 $\mu$m) with indicated scan range. Figure 6(c) shows a measured slope of the in-contact part of the obtained force curves along the normalized length axis x of the reference beam for different excitation frequencies using photothermal off-resonance tapping and spectroscopy. The expected slope is 1.0 at the base, e.g., a hard surface, and around 0.5 at the free end of the reference beam since both, the micromechanical sensor 602 and the reference beam 603 have a similar nominal spring constant. Figure 6(d) shows a measured and simulated sample stiffness versus expected stiffness.

Still referring to Figure 6, for further experimental investigations of the frequency dependence on the measured sample stiffness, a second AFM probe USC-f1.5-k0.617 (Nanoworld AG) was chosen as a reference beam 603, providing a well-defined stiffness profile along its long axis. This ultra-short reference beam has a resonance frequency well above the resonance frequency of the micromechanical sensor 602 in form of a WM0.8PTD (Nanosurf AG), therefore a quasi-static bending behaviour of the reference beam can be expected. The apex of the reference beam 603 was removed using a focused ion beam setup. As indicated in Figure 6(a), the stiffness profile has been acquired through scanning along the long axis of the reference beam 603 in photothermal off-resonance tapping and the slope in the obtained force distance curves was analysed. Two springs in series have been assumed as model where the inverse of the effective spring constant $k_{eff}$ of the system is the sum of the inverses of the micromechanical sensor spring constant $k_{probe}$ and the reference beam spring constant $k_{ref}$. For two springs in series, the effective spring constant may be calculated according to formula (1).

$$k_{eff} = \frac{k_{probe}k_{ref}}{k_{probe}+k_{ref}} \qquad (7)$$

$$k_{ref} = \frac{3E_{Ref}I_{Ref}}{L_{Ref}^3} \qquad (8)$$

The expected stiffness profile of the reference beam 603 may be obtained from the formula of the spring constant of a leaf spring considering geometrical dimensions ($I_{Ref}$, $L_{Ref}$) and the Young's modulus $E_{Ref}$ of the micromechanical sensor material according to equation (2). The reference beam 603 thickness of, e.g., 265 nm, and length may be determined from AFM measurements, while the Young's modulus, e.g., of 274 GPa, may be calculated using formula (2).

The obtained effective stiffness profile is a superposition of the stiffness profile of the reference beam 603 and the spring constant of the micromechanical sensor 602. Close to the base of the reference beam 603, only the micromechanical sensor 602 is deformed during the measurement, hence the effective stiffness is equal to $k_{probe}$ in this regime. $k_{ref}$ seems infinite stiff here. Closer to the free end of the reference beam 603, both the micromechanical sensor 602 and the reference beam 603 are deformed, resulting in an effective stiffness profile with contribution from both the micromechanical sensor 602 and the reference beam 603, based on the ratio between $k_{probe}$ and $k_{ref.}$

Other variations to the disclosed embodiments can be understood and effected by those skilled in the art in practicing the claimed invention, from a study of the drawings, the disclosure, and the appended claims.

For the processes and methods disclosed herein, the operations performed in the processes and methods may be implemented in differing order. Furthermore, the outlined operations are only provided as examples, and some of the operations may be optional, combined into fewer steps and operations, supplemented with further operations, or expanded into additional operations without detracting from the essence of the disclosed embodiments.

In the claims, the word "comprising", "including", or "containing" does not exclude other elements or steps, and the indefinite article "a" or "an" does not exclude a plurality.

A single unit or device may fulfil the functions of several items recited in the claims. The mere fact that certain measures are recited in mutually different dependent claims does not indicate that a combination of these measures cannot be used to advantage.

Procedures like obtaining a first quantity, obtaining a second quantity, providing at least one first calibration value, providing at least one second calibration value and determining the at least one property of the sample can be performed by any other number of modules, units, or devices. These procedures can be implemented as program code means of a computer program and/or as dedicated hardware.

A computer program product may be stored/distributed on a suitable medium, such as an optical storage medium or a solid-state medium, supplied together with or as part of other hardware, but may also be distributed in other forms, such as via the Internet or other wired or wireless telecommunication systems.

Any modules or units described herein may be processing units that are part of a classical computing system. Processing units may include a general-purpose processor and may also include a FPGA, an ASIC, or any other specialized circuit. Any memory may be a physical system memory, which may be volatile, non-volatile, or some combination of the two. The term "memory" may include any computer-readable storage media such as a non-volatile mass storage. If the computing system is distributed, the processing and/or memory capability may be distributed as well. The computing system may include multiple structures as "executable components". The term "executable component" is a structure well understood in the field of computing as being a structure that can be software, hardware, or a combination thereof. For instance, when implemented in software, one of ordinary skill in the art would understand that the structure of an executable component may include software objects, routines, methods, modules, and so forth, that may be executed on the computing system. This may include both an executable component in the heap of a computing system, or on computer-readable storage media. The structure of the executable component may exist on a computer-readable medium such that, when interpreted by one or more processors of a computing system, e.g., by a processor thread, the computing system is caused to perform a function. Such structure may be computer readable directly by the processors, for instance, as is the case if the executable component were binary, or it may be structured to be interpretable and/or compiled, for instance, whether in a single stage or in multiple stages, so as to generate such binary that is directly interpretable by the processors. In other instances, structures may be hard coded or hard wired logic gates, that are implemented exclusively or near-exclusively in hardware, such as within a FPGA, an ASIC, or any other specialized circuit. Accordingly, the term "executable component" is a term for a structure that is well understood by those of ordinary skill in the art of computing, whether implemented in software, hardware, or a combination. Any embodiments herein are described with reference to acts that are performed by one or more processing units of the computing system. If such acts are implemented in software, one or more processors direct the operation of the computing system in response to having executed computer-executable instructions that constitute an executable component. Computing system may also contain communication channels that allow the computing system to communicate with other computing systems over, for example, network. A "network" is defined as one or more data links that enable the transport of electronic data between computing systems and/or modules and/or other electronic devices. When information is transferred or provided over a network or another communications connection, for example, either hardwired, wireless, or a combination of hardwired or wireless, to a computing system, the computing system properly views the connection as a transmission medium. Transmission media can include a network and/or data links which can be used to carry desired program code means in the form of computer-executable instructions or data structures and which can be accessed by a general-purpose or special-purpose computing system or combinations. While not all computing systems require a user interface, in some embodiments, the computing system includes a user interface system for use in interfacing with a user. User interfaces act as input or output mechanism to users for instance via displays.

Those skilled in the art will appreciate that at least parts of the invention may be practiced in network computing environments with many types of computing system configurations, including, personal computers, desktop computers, laptop computers, message processors, hand-held devices, multi-processor systems, microprocessor-based or programmable consumer electronics, network PCs, minicomputers, main-frame computers, mobile telephones, PDAs, pagers, routers, switches, datacentres, wearables, such as glasses, and the like. The invention may also be practiced in distributed system environments where local and remote computing system, which are linked, for example, either by hardwired data links, wireless data links, or by a combination of hardwired and wireless data links, through a network, both perform tasks. In a distributed system environment, program modules may be located in both local and remote memory storage devices.

Those skilled in the art will also appreciate that at least parts of the invention may be practiced in a cloud computing environment. Cloud computing environments may be distributed, although this is not required. When distributed, cloud computing environments may be distributed internationally within an organization and/or have components possessed across multiple organizations. In this description and the following claims, "cloud computing" is defined as a model for enabling on-demand network access to a shared pool of configurable computing resources, e.g., networks, servers, storage, applications, and services. The definition of "cloud computing" is not limited to any of the other numerous advantages that can be obtained from such a model when deployed. The computing systems of the figures include various components or functional blocks that may implement the various embodiments disclosed herein as explained. The various components or functional blocks may be implemented on a local computing system or may be implemented on a distributed computing system that includes elements resident in the cloud or that implement aspects of cloud computing. The various components or functional blocks may be implemented as software, hardware, or a combination of software and hardware. The computing systems shown in the figures may include more or less than the components illustrated in the figures and some of the components may be combined as circumstances warrant.

Any reference signs in the claims should not be construed as limiting the scope.

The present invention relates to determining at least one property of a sample with a device that comprises a micromechanical sensor having an apex. A first quantity indicative of a response of the micromechanical sensor due to an apex-sample-interaction and a second quantity indicative of a response of the micromechanical sensor due to a local actuation force acting locally on or in the micromechanical sensor are obtained. At least one first calibration value for calibrating, e.g., correcting, the first quantity and at least one second calibration value for calibrating, e.g., correcting, the second quantity are provided. The at least one first calibration value is configured for causing a change to one or more determined positions of the apex in the response of the micromechanical sensor due to the apex-sample-interaction. The at least one second calibration value is configured for causing a change to one or more determined positions of the apex in the response of the micromechanical sensor due to the local actuation force acting locally on or in the micromechanical sensor. The at least one property of the sample is determined based on the obtained first quantity, the obtained second quantity, the provided at least one first calibration value and the provided at least one second calibration value.

## Claims

1. A method for determining at least one property of a sample (206; 306) with a device (200; 300) that comprises a micromechanical sensor (202; 302; 402; 602) having an apex (204; 304; 404; 604), the method comprising the steps of:

   - obtaining a first quantity (318) indicative of a response of the micromechanical sensor (202; 302; 402; 602) due to an apex-sample-interaction,
   - obtaining a second quantity (316) indicative of a response of the micromechanical sensor (202; 302; 402; 602) due to a local actuation force acting locally on or in the micromechanical sensor (202; 302; 402; 602),
   - providing at least one first calibration value for calibrating the first quantity, the at least one first calibration value being configured for causing a change to one or more determined positions of the apex (204; 304; 404; 604) in the response of the micromechanical sensor (202; 302; 402; 602) due to the apex-sample-interaction,
   - providing at least one second calibration value (406, 408) for calibrating the second quantity, the at least one second calibration value being configured for causing a change to one or more determined positions of the apex (204; 304; 404; 604) in the response of the micromechanical sensor (202; 302; 402; 602) due to the local actuation force acting locally on or in the micromechanical sensor (202; 302; 402; 602), and
   - determining the at least one property of the sample (206; 306) based on the obtained first quantity (318), the obtained second quantity (316), the provided at least one first calibration value (410, 412) and the provided at least one second calibration value (406, 408).

2. The method according to claim 1, wherein the at least one second calibration value (406, 408) includes a phase correction (406) and/or an amplitude correction (408).

3. The method according to claim 2, wherein the phase correction (406) and/or amplitude correction (408) is determined based on historical data including predetermined amplitude corrections and/or phase corrections for the micromechanical sensor (202; 302; 402; 602).

4. The method according to claim 2 or 3, wherein the phase correction (406) and/or amplitude correction (408) is determined based on:

- a computational model configured for determining the amplitude corrections and/or the phase corrections for the micromechanical sensor (202; 302; 402; 602) for one or more predetermined positions of a local actuation force acting locally on or in the micromechanical sensor (202; 302; 402; 602) and/or one or more predetermined operation frequencies, and/or
- an analytical model that includes one or more properties at least of the micromechanical sensor (202; 302; 402; 602) for determining the amplitude corrections and/or phase corrections for the micromechanical sensor (202; 302; 402; 602) for one or more predetermined positions of a local actuation force acting locally on or in the micromechanical sensor (202; 302; 402; 602) and/or one or more predetermined operation frequencies.

5. The method according to at least one of claims 2 to 4, wherein the phase correction and/or amplitude correction is determined based on one or more of:

- repositioning a local actuation force acting locally on or in the micromechanical sensor (202; 302; 402; 602) so that an effective phase correction is zero,
- applying a known force to the micromechanical sensor (202; 302; 402; 602) or distance difference to the apex (204; 304; 404; 604),
- direct strain measurement at the micromechanical sensor (202; 302; 402; 602),
- measuring a trajectory of the apex (204; 304; 404; 604), and/or
- measuring a quantity causing a bending moment of the micromechanical sensor (202; 302; 402; 602).

6. The method according to at least one of claims 2 to 5, wherein the phase correction and/or amplitude correction is determined based on a measurement on a reference structure of known mechanical properties.

7. The method according to at least one of claims 2 to 6, wherein the phase correction and/or amplitude correction is determined based on comparison of actual beam shape of the micromechanical sensor (202; 302; 402; 602) with known beam behaviour of the micromechanical sensor (202; 302; 402; 602).

8. The method according to at least one of claims 2 to 7, wherein the phase correction and/or amplitude correction is determined based on one or more of:

- obtaining the first quantity by subtracting the second quantity from a measurement of an at least intermittent interaction between the micromechanical sensor (202; 302; 402; 602) and the sample (206; 306),
- measuring a deflection of the micromechanical sensor (202; 302; 402; 602) as a function of position along the micromechanical sensor (202; 302; 402; 602), to reconstruct the bending of the micromechanical sensor (202; 302; 402; 602) over its full length and thereby determining a relation between the actual modulated position and the measured modulated position,
- modelling a bending of the micromechanical sensor (202; 302; 402; 602) as a function of position along the micromechanical sensor (202; 302; 402; 602), to reconstruct the bending of the micromechanical sensor (202; 302; 402; 602) over its full length and thereby determining a relation between the actual modulated position and the measured modulated position, and/or
- measuring the second quantity as a function of frequency or time, and by combining these measurement data with a model of the expected response.

9. The method according to at least one of claims 2 to 8, wherein the phase correction and/or amplitude correction is determined based on a temporal alignment between a feature in the first quantity due to the vicinity of the sample (206; 306), and a feature in the second quantity, wherein the amplitude correction is determined from a known or modelled relation between the phase correction and the amplitude correction.

10. The method according to at least one of claims 1 to 9, wherein the at least one second calibration value is determined based on one or more of:

- measuring a response of the micromechanical sensor (202; 302; 402; 602) induced by the local actuation force acting locally on or in the micromechanical sensor (202; 302; 402; 602) with a position-sensitive sensor arranged to measure a displacement of the apex (204; 304; 404; 604) and calibrating a micromechanical sensor readout based on the position-sensitive sensor, and/or

- calibrating the micromechanical sensor (202; 302; 402; 602) to obtain calibrated angular measurements and measuring an angle along the micromechanical sensor (202; 302; 402; 602) during response due to the local actuation force acting locally on or in the micromechanical sensor (202; 302; 402; 602) and integrating the angular measurement along the micromechanical sensor (202; 302; 402; 602) to reconstruct a deformation of the micromechanical sensor (202; 302; 402; 602) to obtain a relation between the angle at a position of the apex (204; 304; 404; 604) of the micromechanical sensor (202; 302; 402; 602) and its displacement.

11. The method according to at least one of the claims 1 to 10, wherein the first quantity is derived when the apex (204; 304; 404; 604) is at least transiently in contact with the sample (206; 306) and wherein the second quantity is derived when the apex (204; 304; 404; 604) is not in contact with the sample (206; 306).

12. The method according to at least one of the claims 1 to 11, wherein the at least one second calibration value includes at least one correction to the at least one first calibration value.

13. A device (200; 300) configured for determining at least one property of a sample (206; 306) and comprising a micromechanical sensor (202; 302; 402; 602) having an apex (204; 304; 404; 604), the device (200; 300) further comprising:

- a first quantity obtaining module (214) that is configured for obtaining a first quantity indicative of a response of the micromechanical sensor (202; 302; 402; 602) due to an apex-sample-interaction,
- a second quantity obtaining module (216) that is configured for obtaining a second quantity indicative of a response of the micromechanical sensor (202; 302; 402; 602) due to a local actuation force acting locally on or in the micromechanical sensor,
- a first calibration value providing module (218) that is configured for providing at least one first calibration value for calibrating the first quantity, the at least one first calibration value being configured for causing a change to one or more determined positions of the apex (204; 304; 404; 604) in the response of the micromechanical sensor (202; 302; 402; 602) due to the apex-sample-interaction,
- a second calibration value providing module (220) that is configured for providing at least one second calibration value for calibrating the second quantity, the at least one second calibration value being configured for causing a change to one or more determined positions of the apex (204; 304; 404; 604) in the response of the micromechanical sensor (202; 302; 402; 602) due to the local actuation force acting locally on or in the micromechanical sensor (202; 302; 402; 602), and
- a sample property determination module (222) that is configured for determining the at least one property of the sample (206; 306) based on the obtained first quantity, the obtained second quantity, the provided at least one first calibration value and the provided at least one second calibration value.

14. A computer program for determining at least one property of a sample (206; 306), the computer program including instructions for executing the steps of the method according to at least one of the claims 1 to 12, when run on a processor.

15. A non-transitory computer readable data medium storing the computer program according to claim 14.

S1

S2

S3

S4

S5

Fig. 1

Fig. 2

Fig. 3

Fig. 4

Fig. 5

Fig. 6

# EUROPEAN SEARCH REPORT

**Application Number**

EP 24 21 3465

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2018/106830 A1 (FANTNER GEORG ERNEST [CH] ET AL) 19 April 2018 (2018-04-19) * figures 1-7 * * paragraph [0046] - paragraph [0069] * ----- | 1-15 | INV. G01Q10/04 B81C99/00 G01P21/00 G01Q40/00 |
| A | LABUDA ALEKSANDER ET AL: "Retrofitting an atomic force microscope with photothermal excitation for a clean cantilever response in low Q environments", REVIEW OF SCIENTIFIC INSTRUMENTS, AMERICAN INSTITUTE OF PHYSICS, 2 HUNTINGTON QUADRANGLE, MELVILLE, NY 11747, vol. 83, no. 5, 1 May 2012 (2012-05-01), pages 53703-53703, XP012162304, ISSN: 0034-6748, DOI: 10.1063/1.4712286 [retrieved on 2012-05-10] * the whole document * ----- | 1-15 | |

|  |  |  | TECHNICAL FIELDS SEARCHED (IPC) |
|---|---|---|---|
|  |  |  | G01Q G01P B81C |

The present search report has been drawn up for all claims

| Place of search | Date of completion of the search | Examiner |
|---|---|---|
| Berlin | 17 April 2025 | Polesello, Paolo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

## ANNEX TO THE EUROPEAN SEARCH REPORT
## ON EUROPEAN PATENT APPLICATION NO.

EP 24 21 3465

This annex lists the patent family members relating to the patent documents cited in the above-mentioned European search report.
The members are as contained in the European Patent Office EDP file on
The European Patent Office is in no way liable for these particulars which are merely given for the purpose of information.

17-04-2025

| Patent document cited in search report | Publication date | Patent family member(s) | | Publication date |
|---|---|---|---|---|
| US 2018106830 A1 | 19-04-2018 | EP | 3295186 A1 | 21-03-2018 |
| | | EP | 4439077 A2 | 02-10-2024 |
| | | US | 2018106830 A1 | 19-04-2018 |
| | | WO | 2016181325 A1 | 17-11-2016 |

For more details about this annex : see Official Journal of the European Patent Office, No. 12/82